# EUROPÄISCHE PATENTSCHRIFT

(11) **EP 3 944 418 B1**
(45) Veröffentlichungstag und Bekanntmachung des Hinweises auf die Patenterteilung: **21.02.2024**
(21) Anmeldenummer: 21185291.8
(22) Anmeldetag: 13.07.2021
(51) Int. Cl.: H01R 4/02, H01R 12/53, H01R 43/02, H05K 3/34, H01R 12/57, H05K 1/18

(54) **LÖTHILFSTEIL ZUM VERBINDEN EINES KABELS MIT EINER LEITERPLATTE; KABEL; LEITERPLATTE; BAUGRUPPE; VERFAHREN**
SOLDERING AID FOR CONNECTING A CABLE WITH A CIRCUIT BOARD; CABLE; CIRCUIT BOARD; ASSEMBLY; METHOD
AIDE AU BRASAGE PERMETTANT DE RELIER UN CÂBLE À UNE CARTE DE CIRCUIT IMPRIMÉ, CÂBLE, CARTE DE CIRCUIT IMPRIMÉ, MODULE, PROCÉDÉ

(30) Priorität: 23.07.2020 DE 102020119422
(43) Veröffentlichungstag der Anmeldung: 26.01.2022
(73) Patentinhaber: MD Elektronik GmbH, 84478 Waldkraiburg (DE)
(72) Erfinder: Mittermaier, Gerd, 84453 Mühldorf am Inn (DE); Borkowski, Matthias, 84332 Hebertsfelden (DE); Lechleitner, Nikolaus, 6675 Tannheim (AT); Friesinger, Johann, 83562 Rechtmehring (DE); Haas, Alexander, 84453 Mühldorf am Inn (DE); Stömmer, Christian, 85435 Erding (DE); Sterkel, Martin, 83209 Prien (DE); Rissing, Lutz, 80337 München (DE)

(56) Entgegenhaltungen:
- DE-A1-102011 076 817
- DE-A1-102013 215 145
- DE-A1-102017 218 541
- US-A1- 2020 203 854

## Beschreibung

Die Erfindung betrifft ein Löthilfsteil zum Verbinden eines Kabels mit einer Leiterplatte. Die Erfindung betrifft weiter ein Kabel, eine Leiterplatte sowie eine Baugruppe mit einem solchen Löthilfsteil. Zudem betrifft die Erfindung ein Verfahren zum Verbinden eines Kabels mit einer Leiterplatte unter Verwendung eines solchen Löthilfsteils.

Kabel werden eingesetzt, um elektrische oder elektronische Geräte signaltechnisch und/oder energietechnisch an eine andere Vorrichtung anzukoppeln. Eine Leiterplatte mit elektrischen/elektronischen Komponenten des Geräts hat dazu einen entsprechenden Anschluss, der an ein Kabelendstück gekoppelt werden kann, sodass z.B. ein elektrischer Strom und/oder ein Steuersignal und/oder ein Kommunikationssignal über das Kabel zwischen Gerät und Vorrichtung übertragen werden kann.

Aus dem Stand der Technik ist eine Vielzahl von Möglichkeiten bekannt, eine elektrische Verbindung durch Löten auszubilden.

Die DE 10 2008 013 226 A1 beschreibt eine Lötverbindung zur Befestigung eines Surface-Mount-Device (SMD) Teils über eine Kontaktfläche auf einer Lötpaste, die innerhalb einer Vertiefung in der Leiterplatte angeordnet ist. Dort muss die Leiterplatte entsprechend vorbereitet und mit den Vertiefungen versehen werden.

Die US 5,021,630 beschreibt die Befestigung eines elektronischen Bauteils auf einem Substrat mittels einer Glasplatte, die unter Bestrahlung mittels eines Lasers erwärmt, so dass ein Lot schmilzt.

Mit Blick auf die Befestigung einer Litze eines Kabels beschreibt die EP 3 477 798 A1 eine Vorrichtung zum Befestigen einer ersten Litze in einem Gehäuse mittels einer Andrückvorrichtung, die die erste Litze vorfixiert, damit eine zweite Litze in dem Gehäuse ebenfalls befestigt werden kann.

Die DE 100 46 489 C1 beschreibt einen elektrischen Leiter an einer Trägerfolie, der mittels eines Anschlusselements auf einer Kontaktfläche durch Löten befestigt werden kann, wobei ein Einsatzstück ein Lotdepot umfasst und als Crimpstück ausgebildet ist. Ein Schmelzen des Lotdepots kann durch Wärmezufuhr mittels eines Lasers bewirkt werden. DE 10 2011 076 817 A1 beschreibt eine Löthilfe zum Verbinden mindestens einer, insbesondere mehrerer Anschlussleitungen eines Peripheriemoduls eines Steuergerätes mit einer Leiterplatte, wobei in einer Aussparung des Moduls für jede Anschlussleitung ein Basiselement vorgesehen ist, um mit einer Litze der Anschlussleitung verbunden zu werden. Die jeweilige Litze der Anschlussleitung ist mit einem Fügeelement versehen, das mit dem jeweiligen Basiselement elektrisch leitend verbunden, nämlich verschweißt ist. Die nicht-abgemantelten Teile der Kabelendstücke der jeweiligen Anschlussleitung sind in dem Peripheriemodul angeordnet. Das jeweilige Basiselement, das insbesondere als Schweißgabel ausgebildet ist, ist auf eine Kontaktstelle der Leiterplatte aufgelötet.

Aufgabe der vorliegenden Erfindung ist es, ein Ausbilden einer Lötverbindung zwischen einer Litze eines Kabels und einem Anschluss einer Leiterplatte zu vereinfachen.

Hiervon ausgehend wird der Gegenstand des unabhängigen Anspruchs 1 vorgeschlagen. Merkmale einiger Ausführungsbeispiele sind in den abhängigen Ansprüchen angegeben. Die Merkmale der abhängigen Ansprüche können miteinander zur Ausbildung weiterer Ausführungsformen kombiniert werden, sofern nicht ausdrücklich etwas Anderes angegeben ist.

Gemäß einem ersten Aspekt umfasst ein Löthilfsteil zum Verbinden eines Kabels mit einer Leiterplatte einen elektrisch isolierenden Körper mit einer ersten Aussparung, einer zweiten Aussparung und einer dritten Aussparung sowie eine mit dem Körper gekoppelte elektrisch leitfähige Kontaktstruktur, wobei die Kontaktstruktur abschnittsweise in den Körper eingelassen ist, um im Inneren des Körpers mit einer Litze des Kabels verbunden zu werden, und abschnittsweise aus dem Körper hinaustritt, um mit einem Anschluss der Leiterplatte verbunden zu werden. Die erste Aussparung ist zur Aufnahme eines Endstücks des Kabels ausgebildet und weist einen ersten Abschnitt für einen nicht-abgemantelten Teil des Kabelendstücks und einen zweiten Abschnitt für einen abgemantelten Teil des Kabelendstücks auf, wobei der abgemantelte Teil des Kabelendstücks die Litze umfasst und die Kontaktstruktur an den zweiten Abschnitt angrenzt. Die erste Aussparung ist bevorzugt insbesondere verjüngend, speziell konisch verjüngend, also mit zu der zweiten Aussparung hin abnehmenden Durchmesser ausgebildet. Die zweite Aussparung ist räumlich versetzt zur ersten Aussparung ausgebildet und grenzt mit ihrem Ende an den zweiten Abschnitt der ersten Aussparung an, um eine optische Kontrolle der Ausbildung der Verbindung zwischen der Litze und der Kontaktstruktur zu ermöglichen. Die dritte Aussparung ist räumlich versetzt zur ersten Aussparung ausgebildet und zur zweiten Aussparung und grenzt mit ihrem Ende an den zweiten Abschnitt der ersten Aussparung an, wobei die dritte Aussparung zur Aufnahme und Weiterleitung von Lot in den zweiten Abschnitt der ersten Aussparung ausgebildet ist, um dort die Verbindung zwischen der Litze und der Kontaktstruktur zu formen.

Gemäß einem zweiten Aspekt weist ein Kabel an seinem Endstück ein dort angebrachtes Löthilfsteil gemäß dem ersten Aspekt auf.

Gemäß einem dritten Aspekt weist eine Leiterplatte an einem Anschluss der Leiterplatte ein dort angebrachtes Löthilfsteil gemäß dem ersten Aspekt auf.

Gemäß einem vierten Aspekt umfasst eine Baugruppe ein Kabel und eine Leiterplatte, wobei das Kabel und die Leiterplatte durch ein Löthilfsteil gemäß dem ersten Aspekt miteinander verbunden sind.

Gemäß einem fünften Aspekt umfasst ein Verfahren zum Verbinden einer Leiterplatte mit einem Kabel ein Ausbilden einer elektrisch leitfähigen Verbindung zwischen einer Litze des Kabels und einem Anschluss der Leiterplatte unter Verwendung eines Löthilfsteils gemäß dem ersten Aspekt.

Nachstehend werden einige Ausführungsformen des Löthilfsteils beschrieben. Die Beschreibung gilt analog für das Kabel, die Leiterplatte, die Baugruppe sowie das Verfahren.

Der Körper des Löthilfsteils weist z.B. eine Oberseite, eine Unterseite sowie eine Stirnseite auf. Die Kontaktstruktur tritt an der Unterseite aus dem Körper hinaus, um mit dem Anschluss der Leiterplatte (beispielsweise ein Löt-Pad) verbunden zu werden. Diese Verbindung wird beispielsweise durch einen Lötvorgang hergestellt, beispielweise im Rahmen eines sog. Reflow-Prozesses.

Die erste Aussparung ist z.B. an der Körperstirnseite ausgebildet erstreckt sich parallel zur Körperunterseite in den Körper.

Die zweite Aussparung und die dritte Aussparung sind z.B. an der Körperoberseite ausgebildet und erstrecken sich versetzt voneinander und senkrecht zur Körperunterseite in den Körper.

Die drei Aussparungen sind z.B. jeweils durch Bohrungen hergestellt und weisen eine entsprechende Zylinderform auf.

Gemäß einer Ausführungsform verlaufen die zweite Aussparung und die dritte Aussparung parallel zueinander, z.B. von der Körperoberseite in Richtung Körperunterseite. Dabei sind die zweite Aussparung und die dritte Aussparung versetzt zueinander angeordnet, beispielsweise in Richtung der Erstreckung der ersten Aussparung. Der Raum zwischen der zweiten Aussparung und der dritten Aussparung ist durch das Material des Körpers gefüllt.

Die zweite Aussparung und die dritte Aussparung münden im zweiten Abschnitt der ersten Aussparung. Auch die Kontaktstruktur grenzt an diesen zweiten Abschnitt an, z.B. derart, dass sie um einen geringen Betrag in den zweiten Abschnitt der ersten Aussparung hineinreicht. Jedenfalls begrenzt die Kontaktstruktur den zweiten Abschnitt der ersten Aussparung derart, dass Lotmaterial in dem zweiten Abschnitt der ersten Aussparung in elektrisch leitenden Kontakt mit der Kontaktstruktur gelangen kann.

Gemäß einer Ausführungsform ist die Kontaktstruktur als Profilteil, z.B. mit einem U- oder L-förmigen Querschnittsprofil, ggf. auch mit einem z-förmigen oder stufenförmigen, Querschnittsprofil, ausgebildet und tritt mit einem ersten Schenkel aus dem Körper hinaus, sodass der erste Schenkel mit dem Anschluss der Leiterplatte verbunden werden kann; dabei grenzt die Kontaktstruktur mit einem zweiten Schenkel des Profilteils an den zweiten Abschnitt der ersten Aussparung an, sodass der zweite Schenkel des Profilteils durch das in dem zweiten Abschnitt der ersten Aussparung befindliche Lotmaterial mit der Litze des Kabels elektrisch leitend verbunden werden kann.

Nach einer Ausführungsform ist der zweite Abschnitt der ersten Aussparung im Querschnitt gegenüber dem ersten Abschnitt verkleinert und an einem Übergang zwischen dem ersten Abschnitt und dem zweiten Abschnitt der ersten Aussparung eine Stufe entsprechend dem Querschnittsunterschied ausgebildet. Die drei Aussparungen sind derart positioniert und dimensioniert sind, dass ein Mantel des nicht-abgemantelten Teils des Kabelendstücks an die Stufe angrenzt, wenn die Litze des abgemantelten Teils des Kabelendstücks im zweiten Abschnitt der ersten Aussparung sowohl an das Ende der zweiten Aussparung als auch das Ende der dritten Aussparung angrenzt.

Der Körper des Löthilfsteils ist aus einem elektrisch isolierenden Material gefertigt. Um einem Lötvorgang standhalten zu können, ist das Körpermaterial bevorzugt auch hitzebeständig, beispielweise ein Duroplast. Die erste Aussparung zur Aufnahme des Kabelendstücks ist bei einer Ausführungsform mit einem Befestigungsmittel versehen, z.B. einem Klemmmechanismus, der das Kabelendstück nach Einführung in die erste Aussparung dort fixiert. Zur Ausbildung des Klemmechanismus ist die erste Aussparung verjüngend, insbesondere konisch verjüngend, ausgebildet; zur Ausbildung der konischen Verjüngung nimmt der Durchmesser der ersten Aussparung in Richtung zu der zweiten Aussparung bzw. zu der dritten Aussparung hin ab. Dabei fixiert das Befestigungsmittel, insbesondere der sich konisch verjüngende Verlauf der ersten Aussparung, den nicht-abgemantelten Teil des Kabelendstücks im ersten Abschnitt, beispielsweise indem der Mantel des Kabelendstücks im ersten Abschnitt geklemmt, gegriffen, verrastet oder in sonstiger Weise befestigt wird.

Die elektrisch leitfähige Kontaktstruktur ist z.B. aus Kupferbronze gefertigt. Sie kann monolithisch ausgebildet sein.

Bei dem Kabel kann es sich um Kabel zur Übertragung eines elektrischen Stroms oder eines Steuer-oder Kommunikationssignals handeln. Die Litze ist entsprechend den jeweiligen Anforderungen ausgebildet und dimensioniert. Das Löthilfsteil erlaubt insbesondere auch die Verbindung einer Litze mit sehr kleiner Querschnittsfläche, beispielsweise einer Querschnittsfläche von weniger als ca. 0,35 mm².

Der Anschluss der Leiterplatte ist beispielsweise durch ein Löt-Pad oder dergleichen gebildet. Der Begriff der Leiterplatte ist hier breit zu verstehen; erfasst sind damit jedwede (insbesondere auch nicht im engeren Sinne plattenförmige) Träger elektrischer/elektronischer Komponenten, von denen zumindest eine über eine elektrisch leitfähige Kopplung mit dem Anschluss verbunden ist. Diese Kopplung kann z.B. eine integrierte oder auflaminierte Leiterbahn umfassen.

Die oben beschriebene Anordnung mit den drei in den Körper hineinragenden Aussparungen sowie der Kontaktstruktur ist gemäß einer Ausführungsform in mehrfacher Weise im Körper des Löthilfsteils implementiert, sodass eine Vielzahl von Litzen (auch unterschiedlicher Größe) eines oder mehrerer Kabel mit der Leiterplatte verbunden werden können. Z.B. sind über das Löthilfsteil sowohl eine oder mehrere Datenleitungen als auch eine oder mehrere Powerleitungen eines einzigen Kabels mit entsprechenden Anschlüssen einer Leiterplatte verbunden.

Die durch den abgemantelten Teil des Kabelendstücks im zweiten Abschnitt der ersten Aussparung exponierte Litze ist dadurch, dass die zweite Aussparung und die dritte Aussparung mit ihren Enden an den zweiten Abschnitt der ersten Aussparung angrenzen, über die zweite Aussparung und die dritte Aussparung erreichbar bzw. einsehbar.

Die dritte Aussparung hält das Lot bereit und bildet somit z.B. ein Lotdepot aus, wobei auch das Endstück eines Lotdrahtes in die dritte Aussparung eingelassen sein kann. Durch Wärmeeintrag kann das Lot verflüssigt werden und somit im zweiten Abschnitt der ersten Aussparung mit der Kontaktstruktur verbunden werden.

Der Wärmeeintrag erfolgt beispielsweise durch Laserbestrahlung, wobei die Laserstrahlen z.B. durch die zweite Aussparung geführt werden, um die Wärme möglichst lokal im zweiten Abschnitt der ersten Aussparung zu erzeugen. Die zweite Aussparung erlaubt es somit, zeitlich vor dem Lötvorgang, insbesondere zeitlich vor dem Erwärmen des Lots, optisch zu kontrollieren, ob das Kabelendstück mit der Litze korrekt in der ersten Aussparung positioniert ist. Weiter ermöglicht die zweite Aussparung während des Lötvorgangs bzw. zur Bewirkung des Lötvorgangs gezielt Wärme einzukoppeln und nach dem Lötvorgang die Ausbildung der Verbindung zu kontrollieren.

Optional wird die korrekte Positionierung der Litze zusätzlich oder alternativ zur optischen Kontrolle unter Verwendung eines Kraftsensors kontrolliert, der z.B. während des Einführens des Kabels in die erste Aussparung einen Anstoß des Kabelmantels an der Stufe der ersten Aussparung detektiert.

Sämtliche oben beschriebene Schritte betreffend das Ausbilden der Lötverbindung zwischen Litze und Kontaktstruktur sowie Kontaktstruktur und Leiterplattenanschluss sind gemäß einer Ausführungsform des Verfahrens automatisiert durch entsprechende Prozessautomaten durchgeführt.

Gemäß einer bevorzugten Durchführung des erfindungsgemäßen Verfahrens zum Verbinden einer Leiterplatte mit einem Kabel ist vorgesehen, dass zuerst die Lötverbindung zwischen Litze und Kontaktstruktur im Inneren des Körpers des Löthilfsteils hergestellt wird, beispielsweise im Rahmen eines Reflow-Prozesses nach einer vorherigen Positionierung des Löthilfsteils an dem mit einer zur Vorfixierung mit Lötpaste versehenen Anschluss der Leiterplatte (z.B. via "Pick-and-Place") durch einen Bestückungsautomaten, und danach die Verbindung zwischen Kontaktstruktur und Leiterplattenanschluss. Auf diese Weise können Kabel, die unter Verwendung eines Löthilfsteils vorab bestückt wurden und als Zwischenprodukte vorrätig gehalten werden, im Bedarfsfall zügig und kostensparend mit der Leiterplatte verbunden werden; insbesondere kann das Verbinden der Kabel mit den Löthilfsteilen prozesstechnisch parallel und zeitlich wenig versetzt zu der Befestigung der Löthilfsteile auf der Leiterplatte durchgeführt werden. Bei einer alternativen Ausführungsform erfolgt die Ausbildung der Verbindungen in umgekehrter Reihenfolge, also zunächst die Lötverbindung zwischen Kontaktstruktur und Leiterplattenanschluss und dann die Verbindung des Kabels mit dem Löthilfsteil. Bei dieser alternativen Durchführung kann vermieden werden, dass die Lötverbindung zwischen Litze und Kontaktstruktur im Inneren des Körpers etwaigen Besonderheiten eines Prozesses zum Verbinden der Kontaktstruktur mit dem Leiterplattenanschluss (z.B. Reflow-Prozess) standhalten muss. Unabhängig von der Reihenfolge der Prozessschritte ist insbesondere vorgesehen, dass ein Löthilfsteil mit den Merkmalen des Anspruchs 1 Verwendung findet.

Das hier beschriebene Löthilfsteil kann somit in vorteilhafter Weise mehrere Funktionen erfüllen, z.B. das Führen der Litze, die Fixierung der Litze, die Bereitstellung von Lot für die Verbindung zwischen Litze und Kontaktstruktur im Inneren des Körpers, als auch die optische Prüfung der Positionierung der Litze und der erzeugten Verbindung. Somit ist z.B. eine vorteilhafte "Wire-To-Board" Löthilfe bereitgestellt, mit der eine dauerhafte, nicht-lösbare Verbindung zwischen Kabel und Leiterplatte geschaffen werden kann.

Als Lotmaterial können im Rahmen der vorliegenden Erfindung bekannte Metalllegierungen eingesetzt werden; alternativ ist auch die Verwendung von elektrisch leitfähigen Klebstoffen möglich.

Weitere Einzelheiten und Vorteile der Erfindung werden bei der nachfolgenden Beschreibung einiger Ausführungsbeispiele anhand der Figuren deutlich werden.

Es zeigen:
- Fig. 1: exemplarisch und schematisch einen Abschnitt einer Querschnittsansicht einer Baugruppe mit einem Löthilfsteil gemäß einer ersten Ausführungsform; und
- Fig. 2: exemplarisch und schematisch einen Abschnitt einer Querschnittsansicht einer Baugruppe mit einem Löthilfsteil gemäß einer zweiten Ausführungsform.

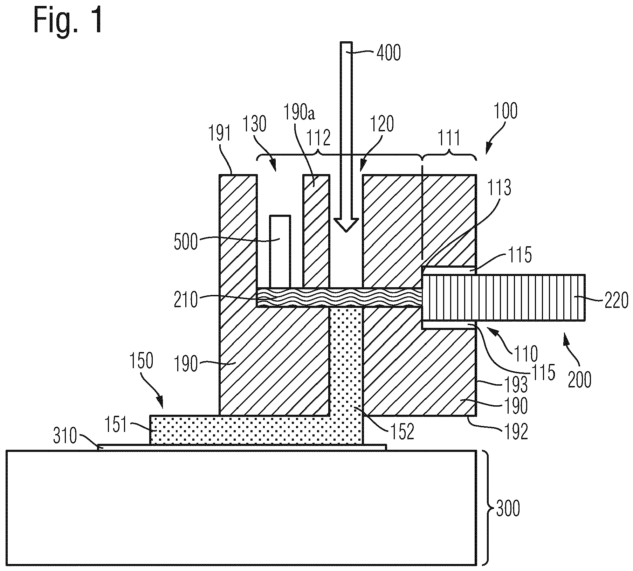

Figur 1 zeigt schematisch und exemplarisch eine Baugruppe mit einer Leiterplatte 300 und einem Kabel 200. Eine Litze 210 des Kabels 200 ist mit einem Anschluss 310 der Leiterplatte 300 elektrisch verbunden.

Zum Verbinden des Kabels 200 mit der Leiterplatte 300 ist ein Löthilfsteil 100 vorgesehen.

Das Löthilfsteil 100 umfasst einen elektrisch isolierenden Körper 190 mit einer ersten Aussparung 110, einer zweiten Aussparung 120 und einer dritten Aussparung 130 sowie eine mit dem Körper 190 gekoppelte elektrisch leitfähige Kontaktstruktur 150.

Die Aussparungen 110, 120 und 130 sind jeweils als Bohrungen, insbesondere als Sackloch-Bohrungen, ausgebildet.

Die Kontaktstruktur 150 ist beispielsweise von dem Körper 190 umspritzt ausgebildet und z.B. aus Kupferbronze oder einem anderen gut leitfähigen Material gefertigt. Die Kontaktstruktur 150 ist bei der beiden dargestellten Ausführungsformen einteilig ausgebildet.

Der Körper 190 ist aus einem hitzebeständigen Material, z.B. einem Duroplast oder einem anderen Kunststoff, gefertigt.

Die Kontaktstruktur 150 ist abschnittsweise in dem Körper 190 aufgenommen, insbesondere innerhalb des Körpers 190 durch abschnittsweises Umspritzen bzw. abschnittsweises Umgießen mit dem Material des Körpers 190 unverlierbar verbunden, um im Inneren des Körpers 190 mit der Litze 210 des Kabels 200 verbunden zu werden. Weiter ist vorgesehen, dass die Kontaktstruktur 150 abschnittsweise aus dem Körper 190 hinaustritt, um mit dem Anschluss 310 der Leiterplatte 300 verbunden, insbesondere elektrisch leitend verbunden, zu werden. Beide Verbindungen, nämlich die Verbindung der Litze 210 des Kabels 200 mit der Kontaktstruktur 150 sowie die Verbindung der Kontaktstruktur 150 mit dem Anschluss 310 der Leiterplatte, können durch einen Lötvorgang realisiert werden, wie nachstehend noch beschrieben werden wird.

Die erste Aussparung 110 nimmt ein Endstück des Kabels 200 auf und weist einen ersten Abschnitt 111 für einen nicht-abgemantelten Teil des Kabelendstücks und einen zweiten Abschnitt 112 für einen abgemantelten Teil des Kabelendstücks auf.

Der abgemantelte Teil des Kabelendstücks weist die Litze 210 des Kabels 200, die durch das Abmanteln freigelegt ist, wobei die Litze 210 in dem zweiten Abschnitt 112 der ersten Aussparung 110 aufgenommen ist. Die Kontaktstruktur 150 grenzt an den zweiten Abschnitt 112 an, so dass Lotmaterial, das in dem zweiten Abschnitt 112 gelangt ist, in elektrisch leitenden Kontakt mit der Kontaktstruktur 150 gelangt.

Die zweite Aussparung 120 ist räumlich versetzt zur ersten Aussparung 110 ausgebildet und grenzt mit ihrem Ende an den zweiten Abschnitt 112 der ersten Aussparung 110 an, um eine optische Kontrolle der Ausbildung der Verbindung zwischen der Litze 210 und der Kontaktstruktur 150 zu ermöglichen. Zwischen der als Sacklochbohrung ausgestalteten zweiten Aussparung 120 und der ebenfalls als Sacklochbohrung ausgestalteten dritten Aussparung 130 ist ein Abschnitt 190a des Körpers 190 belassen, der die beiden Aussparungen 120 und 130 voneinander beabstandet hält; im Bereich dieses Abschnitts ist die die Materialdicke des Körpers 190 nicht reduziert. Der Abschnitt 190a verhindert ein Übertreten von Streustrahlung von der einen Aussparung in die andere Aussparung. Die beiden jeweils als Sacklochbohrung ausgebildeten Aussparungen 120, 130 enden bzw. münden in der ebenfalls als Sacklochbohrung ausgebildeten ersten Aussparung 110.

Die dritte Aussparung 130 ist räumlich versetzt zur ersten Aussparung 110 und zur zweiten Aussparung 120 ausgebildet und grenzt mit ihrem Ende an den zweiten Abschnitt 112 der ersten Aussparung 110 an, wobei die dritte Aussparung zur Aufnahme und Weiterleitung von Lot 500 in den zweiten Abschnitt 112 der ersten Aussparung 110 ausgebildet ist, um dort die Verbindung zwischen der Litze 210 und der Kontaktstruktur 150 zu formen.

Der Körper 190 des Löthilfsteils 100 weist eine Oberseite 191, eine Unterseite 192 sowie eine Stirnseite 193 auf. Die Kontaktstruktur 150 tritt an der Körperunterseite 192 aus dem Körper 190 hinaus, um dort mit dem Anschluss 310 der Leiterplatte 300 verbunden zu werden.

Die erste Aussparung 110 ist an der Körperstirnseite 193 ausgebildet erstreckt sich parallel zur Körperunterseite 192 in den Körper 190.

Die zweite Aussparung 120 und die dritte Aussparung 130 sind an der Körperoberseite 191 ausgebildet und erstrecken sich versetzt voneinander und senkrecht zur Körperunterseite 192 in den Körper 190.

Die drei Aussparungen 110, 120 und 130 sind z.B. jeweils als Bohrungen ausgebildet und weisen eine im Wesentlichen zylindrische Umrissform mit einer im Wesentlichen kreisförmige Querschnittskontur auf. Die Bohrungen sind jeweils als Sacklochbohrung bzw. als Blindbohrung ausgebildet, wobei die Bohrungswandung die erste bzw. zweite Aussparung 120, 130 jeweils vollständig umlaufend umgibt. Das Ende der zweiten Aussparung 120 bzw. das Ende der dritten Aussparung 130 mündet in die Seitenwandung der ersten Aussparung 110, so dass die zweite Aussparung 120 bzw. die dritte Aussparung 130 in die erste Aussparung 110 im Bereich des zweiten Abschnitts 112 übergeht. Der Übergang von der zweiten Aussparung 120 zu der ersten Aussparung 110 ist so ausgelegt, dass ein optischer Kontrollstrahl, beispielsweise eine entlang der Achse der zweiten Aussparung 120 gerichteter Laserstrahl, die in der ersten Aussparung 110 aufgenommen Litze 210 erfassen kann. Weiter ist der Übergang von der dritten Aussparung 130 zu der ersten Aussparung 110 so ausgelegt, dass verflüssigtes Lot 500 aus dem in der dritten Aussparung 130 aufgenommenen Lotdepot in die erste Aussparung 110 übertreten kann, um in der ersten Aussparung 110 die Litze 210 zu benetzen.

Die zweite Aussparung 120 und die dritte Aussparung 130 verlaufen in den dargestellten Ausführungsformen im Wesentlichen parallel zueinander, und zwar von der Körperoberseite 191 in Richtung Körperunterseite 192. Dabei sind die zweite Aussparung 120 und die dritte Aussparung 130 in Richtung der Erstreckung der ersten Aussparung 110 versetzt zueinander und zueinander beabstandet angeordnet und durch den Abschnitt 190a des Körpers 190 getrennt. Das zwischen der zweiten Aussparung 120 und der dritten Aussparung 130 verbliebene Material des Körpers 190 bildet den Abschnitt 190a aus, der die zweite Aussparung 120 und die dritte Aussprung 130 voneinander räumlich beabstandet hält, so dass das Lotdepot und der für die Erfassung der Litze 210 vorgesehene Kontrollstrahl räumlich getrennt werden.

Die zweite Aussparung 120 und die dritte Aussparung 130 münden im zweiten Abschnitt 112 der ersten Aussparung 110, das heißt, dass die zweite Aussparung 120 und die dritte Aussparung 130 jeweils in den zweiten Abschnitt 112 der ersten Aussparung 110 übergehen. Auch die Kontaktstruktur 150 grenzt an diesen zweiten Abschnitt 112, derart, dass die Kontaktstruktur 150 den zweiten Abschnitt 112 der ersten Aussparung 110 zu der Unterseite 192 des Körpers 190 hin begrenzt und abschließt. Insbesondere kann vorgesehen sein, dass die Kontaktstruktur 150 in den zweiten Abschnitt 112 der ersten Aussparung 110 um einen geringen Betrag hineinreicht.

Die durch das Abmanteln des Kabelendstücks freigelegt Litze 210 des Kabels im zweiten Abschnitt 112 der ersten Aussparung 110 ist dadurch, dass die zweite Aussparung 120 und die dritte Aussparung 130 mit ihren Enden in den zweiten Abschnitt 112 der ersten Aussparung 110 münden und übergehen, über die zweite Aussparung 120 und die dritte Aussparung 130 zugänglich bzw. optisch einsehbar.

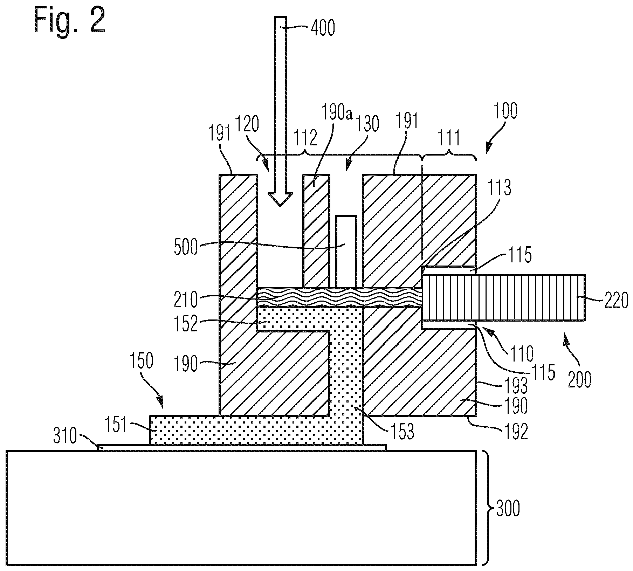

Die Kontaktstruktur 150 ist profilartig ausgebildet, z.B. U-förmig, wie in Fig. 2 veranschaulicht, oder L-förmig, wie in Fig. 1 veranschaulicht.

Die Kontaktstruktur 150 tritt mit einem ersten Schenkel 151 aus dem Körper 190 hinaus und ist mit dem Anschluss 310 der Leiterplatte 300 verbunden. Mit einem zweiten Schenkel 152 grenzt die Kontaktstruktur 150 an den zweiten Abschnitt 112 der ersten Aussparung 110 und ist dort mit der Litze 210 des Kabels 200 verbunden.

Bei dem Beispiel gemäß Fig. 1 ist der zweite Schenkel 152 durch einen Abschnitt der L-förmigen Kontaktstruktur 150 gebildet, und bei dem Beispiel gemäß Fig. 2 ist der zweite Schenkel 152 durch einen Abschnitt der dort U-förmigen Kontaktstruktur 150 gebildet und über einen Steg 153 mit dem ersten Schenkel 151 verbunden.

Der zweite Abschnitt 112 der ersten Aussparung 110 ist bei beiden Beispielen im Querschnitt gegenüber dem ersten Abschnitt 111 verkleinert, und an einem Übergang zwischen dem ersten Abschnitt 111 und dem zweiten Abschnitt 112 der ersten Aussparung 110 ist eine Stufe 113 entsprechend dem Querschnittsunterschied ausgebildet. Die drei Aussparungen 110, 120 und 130 sind derart positioniert und dimensioniert sind, dass ein Mantel 220 des nicht-abgemantelten Teils des Kabelendstücks an die Stufe 113 angrenzt, wenn die Litze 210 des abgemantelten Teils des Kabelendstücks im zweiten Abschnitt 112 der ersten Aussparung 110 sowohl an das Ende der zweiten Aussparung 120 als auch das Ende der dritten Aussparung 130 angrenzt, wie dargestellt.

Weiter ist die erste Aussparung 110 zur Aufnahme des Kabelendstücks mit einer (nur schematisch dargestellten) Klemmung 115 versehen, die den Mantel 220 des Kabelendstücks nach Einführung in die erste Aussparung 110 im ersten Abschnitt 111 fixiert.

Der Anschluss 310 der Leiterplatte 300 ist durch ein Löt-Pad gebildet.

Nachstehend wird ein beispielhaftes Verfahren erläutert, das ein Verbinden der Litze 210 mit dem Anschluss 310 (Löt-Pad) ermöglicht:

Zunächst wird das Kabel 200 in die erste Aussparung 110 eingeführt. Die korrekte Positionierung des Kabels 200 wird optisch kontrolliert. Für die Zwecke der optischen Kontrolle der Positionierung kann sowohl die zweite Aussparung 120 als auch die dritte Aussparung 130 oder nur eine dieser Aussparungen 120, 130 verwendet werden.

Die dritte Aussparung 130 hält nach entsprechender Befüllung das Lot 500 (z.B. als sog. Lot-Preform) bereit und bildet somit z.B. ein Lotdepot aus, wobei auch das Endstück eines Lotdrahtes in die dritte Aussparung 130 eingelassen sein kann. Das Lotdepot 500 ist beispielsweise mechanisch durch eine Klemmung vor Einführung der Litze 210 fixiert, alternativ hierzu kann das Lotdepot als haftende Adhäsionspaste, wie sie für die SMD-Bestückung bekannt ist, bereitgestellt sein. Durch Wärmeeintrag wird das Lot 500 verflüssigt, fließt zur Lötstelle und verbindet im zweiten Abschnitt 112 der ersten Aussparung 110 die Kontaktstruktur 150 mit der Litze 210 elektrisch leitend. Das Lot 500 kann aufgrund des Flusses auch um einen gewissen Betrag beispielsweise durch die Wirkung von Kapillarkräften in der zweiten Aussparung 120 hinaufsteigen. Das Aufsteigen des Lots 500 in der zweiten Aussparung kann beispielsweise optisch erfasst werden.

Der Wärmeeintrag erfolgt beispielsweise durch Laserbestrahlung, wobei die Laserstrahlen (s. Bezugsziffer 400 in Fig. 1 und Fig. 2) z.B. durch die zweite Aussparung 120 geführt werden, um die Wärme möglichst lokal im zweiten Abschnitt 112 der ersten Aussparung 110 zu produzieren. Die zweite Aussparung 120 erlaubt es somit, vor dem Lötvorgang optisch zu kontrollieren, ob das Kabelendstück mit der Litze 210 korrekt in der ersten Aussparung 110 positioniert ist, während des Lötvorgangs bzw. zur Bewirkung des Lötvorgangs gezielt Wärme einzukoppeln und nach dem Lötvorgang die Ausbildung der Verbindung des Lots in der ersten Aussparung 110 mit der Litze 210 zu erfassen.

Um eine Beschädigung des Kabelmantels 220 im ersten Abschnitt 111 der ersten Aussparung 110 aufgrund der Wärmeentwicklung zu vermeiden, ist vorgesehen, die zweite Aussparung 120 im größeren Abstand zum ersten Abschnitt 111 der ersten Aussparung 110 zu positionieren als die dritte Aussparung 130, wie in Fig. 2 veranschaulicht. Entsprechend kann es zweckmäßig sein, die Kontaktfläche der Kontaktstruktur 150 zu verlängern, was durch das U-förmige Profil erreicht wird.

Sämtliche oben beschriebene Schritte betreffend das Ausbilden der Lötverbindung zwischen Litze 210 und der Kontaktstruktur 150 sowie Kontaktstruktur 150 und Leiterplattenanschluss 310 können automatisiert durch entsprechende Prozessautomaten durchgeführt werden.

Vorteilhafterweise wird zuerst die Verbindung zwischen Kontaktstruktur 150 und Leiterplattenanschluss 310 hergestellt, beispielsweise im Rahmen eines Reflow-Prozesses nach einer vorherigen Positionierung des Löthilfsteils 100 an dem mit einer zur Vorfixierung mit Lötpaste versehenen Anschluss 310 der Leiterplatte 300 (z.B. via "Pick-and-Place") durch einen Bestückungsautomaten, und danach die Lötverbindung zwischen Litze 210 und Kontaktstruktur 150 im Inneren des Körpers 190 des Löthilfsteils 100. So wird vermieden, dass die Lötverbindung zwischen Litze 210 und Kontaktstruktur 150 im Inneren des Körpers 190 etwaigen den hohen Temperaturen während eines Reflow-Prozesses zum Verbinden der Kontaktstruktur 150 mit dem Leiterplattenanschluss 310 standhalten muss.

## Patentansprüche

1. Löthilfsteil (100) zum Verbinden eines Kabels (200) mit einer Leiterplatte (300), umfassend:
- einen elektrisch isolierenden Körper (190) mit einer ersten Aussparung (110), einer zweiten Aussparung (120) und einer dritten Aussparung (130); und
- eine mit dem Körper (190) gekoppelte elektrisch leitfähige Kontaktstruktur (150), wobei die Kontaktstruktur (150)
o abschnittsweise in den Körper (190) eingelassen ist, um im Inneren des Körpers (190) mit einer Litze (210) des Kabels (200) verbunden zu werden, und
o abschnittsweise aus dem Körper (190) hinaustritt, um mit einem Anschluss (310) der Leiterplatte (300) verbunden zu werden;
wobei die erste Aussparung (110) zur Aufnahme eines Endstücks des Kabels (200) einen ersten Abschnitt (111) für einen nicht-abgemantelten Teil des Kabelendstücks aufweist, wobei der abgemantelte Teil des Kabelendstücks die Litze (210) umfasst, **dadurch gekennzeichnet,**
**dass** die erste Aussparung (110) zur Aufnahme des Endstücks des Kabels (200) insbesondere konisch verjügend ausgebildet ist,
**dass** die erste Aussparung (110) einen zweiten Abschnitt (112) für einen abgemantelten Teil des Kabelendstücks aufweist, wobei die Kontaktstruktur (150) an den zweiten Abschnitt (112) angrenzt;
**dass** die zweite Aussparung (120) räumlich versetzt zur ersten Aussparung (110) ausgebildet ist und mit ihrem Ende an den zweiten Abschnitt (112) der ersten Aussparung (110) angrenzt, um eine optische Kontrolle der Ausbildung der Verbindung zwischen der Litze (210) und der Kontaktstruktur (150) zu ermöglichen; und
**dass** die dritte Aussparung (130) räumlich versetzt zur ersten Aussparung (110) und zur zweiten Aussparung (120) ausgebildet ist und mit ihrem Ende an den zweiten Abschnitt (112) der ersten Aussparung (110) angrenzt, wobei die dritte Aussparung (130) zur Aufnahme und Weiterleitung von Lot (500) in den zweiten Abschnitt (112) der ersten Aussparung (110) ausgebildet ist, um dort die Verbindung zwischen der Litze (210) und der Kontaktstruktur (150) zu formen.

2. Löthilfsteil (100) nach Anspruch 1, wobei der Körper (190) eine Oberseite (191), eine Unterseite (192) sowie eine Stirnseite (193) aufweist, und wobei:
- die Kontaktstruktur (150) an der Körperunterseite (192) aus dem Körper (190) hinaustritt, um dort mit dem Anschluss (310) der Leiterplatte (300) verbunden zu werden;
- die erste Aussparung (110) an der Körperstirnseite (193) ausgebildet ist und sich parallel zur Körperunterseite (191) in den Körper (190) erstreckt;
- die zweite Aussparung (120) und die dritte Aussparung (130) an der Körperoberseite (191) ausgebildet sind und sich versetzt voneinander und senkrecht zur Körperunterseite (192) in den Körper (190) erstrecken.

3. Löthilfsteil (100) nach Anspruch 1 oder 2, wobei die zweite Aussparung (120) und die dritte Aussparung (130) parallel zueinander verlaufen.

4. Löthilfsteil (100) nach einem der vorstehenden Ansprüche, wobei die Kontaktstruktur (150) profilartig ausgebildet ist und mit einem ersten Schenkel (151) aus dem Körper (190) hinaustritt und mit einem zweiten Schenkel (152) an den zweiten Abschnitt (112) der ersten Aussparung (110) angrenzt.

5. Löthilfsteil (100) nach Anspruch 4, wobei die Kontaktstruktur (150) U- oder L-förmig bzw. z-förmig oder stufenförmig ausgebildet ist.

6. Löthilfsteil (100) nach einem der vorstehenden Ansprüche, wobei
- der zweite Abschnitt (112) der ersten Aussparung (110) im Querschnitt gegenüber dem ersten Abschnitt (111) verkleinert ist und an einem Übergang zwischen dem ersten Abschnitt (111) und dem zweiten Abschnitt (112) der ersten Aussparung (110) eine Stufe (113) entsprechend dem Querschnittsunterschied ausgebildet ist; und
- die drei Aussparungen (110, 120, 130) derart positioniert und dimensioniert sind, dass ein Mantel des nicht-abgemantelten Teils des Kabelendstücks an die Stufe (113) angrenzt, wenn die Litze (210) des abgemantelten Teils des Kabelendstücks im zweiten Abschnitt (112) der ersten Aussparung (110) sowohl an das Ende der zweiten Aussparung (120) als auch das Ende der dritten Aussparung (130) angrenzt.

7. Kabel (200) mit einem an einem Endstück des Kabels (200) angebrachten Löthilfsteil (100) nach einem der vorstehenden Ansprüche.

8. Leiterplatte (300) mit einem an einem Anschluss (310) der Leiterplatte (300) angebrachten Löthilfsteil (100) nach einem der vorstehenden Ansprüche 1-6.

9. Baugruppe umfassend ein Kabel (200), eine Leiterplatte (300) und ein Löthilfsteil (100) nach einem der vorstehenden Ansprüche 1-6, wobei das Kabel und die Leiterplatte durch das Löthilfsteil (100) miteinander verbunden sind.

10. Verfahren zum Verbinden einer Leiterplatte (300) mit einem Kabel (200), wobei das Verfahren umfasst:
- Ausbilden einer elektrisch leitfähigen Verbindung zwischen einer Litze (210) des Kabels (200) und einem Anschluss (310) der Leiterplatte (300) unter Verwendung eines Löthilfsteils (100) nach einem der vorstehenden Ansprüche 1-6, mit den folgenden Schritten:
- Ausbilden einer Lötverbindung zwischen der Kontaktstruktur (150) und dem Leiterplattenanschluss (310), und
- Ausbilden einer Lötverbindung zwischen der Litze (210) und der Kontaktstruktur (150) durch ein Einführen des Kabels (200) in die erste Aussparung (110), wobei die dritte Aussparung (130) nach entsprechender Befüllung das Lot (500) bereithält, und durch ein Verflüssigen des Lots (500) durch Wärmeeintrag, so dass das Lot (500) im zweiten Abschnitt (112) der ersten Aussparung (110) die Kontaktstruktur (150) mit der Litze (210) des Kabels (200) elektrisch leitend verbindet, wobei der Wärmeeintrag beispielsweise durch Laserstrahlung durch die zweite Aussparung (120) erfolgt.

## Claims

1. Soldering aid (100) for connecting a cable (200) to a printed circuit board (300), comprising:
- an electrically insulating body (190) having a first cutout (110), a second cutout (120) and a third cutout (130); and
- an electrically conductive contact structure (150), which is coupled to the body (190), wherein the contact structure (150)
∘ is in part embedded into the body (190) in order to be connected to a litz wire (210) of the cable (200) in the interior of the body (190), and
∘ in part exits from the body (190) in order to be connected to a connection (310) of the printed circuit board (300);
wherein the first cutout (110) for receiving an end piece of the cable (200) has a first section (111) for a non-stripped portion of the cable end piece, wherein the stripped portion of the cable end piece comprises the litz wire (210),
**characterized**
**in that** the first cutout (110) for receiving the end piece of the cable (200) is of in particular conically tapering design,
**in that** the first cutout (110) has a second section (112) for a stripped portion of the cable end piece, wherein the contact structure (150) adjoins the second section (112),
**in that** the second cutout (120) is formed spatially offset in relation to the first cutout (110) and by way of its end adjoins the second section (112) of the first cutout (110) in order to allow optical monitoring of the formation of the connection between the litz wire (210) and the contact structure (150); and
**in that** the third cutout (130) is formed spatially offset in relation to the first cutout (110) and in relation to the second cutout (120) and by way of its end adjoins the second section (112) of the first cutout (110), wherein the third cutout (130) is designed for receiving and passing solder (500) to the second section (112) of the first cutout (110) in order to form the connection between the litz wire (210) and the contact structure (150) there.

2. Soldering aid (100) according to Claim 1, wherein the body (190) has a top side (191), a bottom side (192) and an end side (193), and wherein:
- the contact structure (150) exits from the body (190) at the body bottom side (192) in order to be connected to the connection (310) of the printed circuit board (300) there;
- the first cutout (110) is formed on the body end side (193) and extends into the body (190) parallel in relation to the body bottom side (191);
- the second cutout (120) and the third cutout (130) are formed on the body top side (191) and extend into the body (190) offset from one another and perpendicularly in relation to the body bottom side (192) .

3. Soldering aid (100) according to Claim 1 or 2, wherein the second cutout (120) and the third cutout (130) run parallel in relation to each other.

4. Soldering aid (100) according to any of the preceding claims, wherein the contact structure (150) is of profile-like design and by way of a first limb (151) exits from the body (190) and by way of a second limb (152) adjoins the second section (112) of the first cutout (110).

5. Soldering aid (100) according to Claim 4, wherein the contact structure (150) is of U- or L-shaped or z-shaped or step-like design.

6. Soldering aid (100) according to any of the preceding claims, wherein
- the second section (112) of the first cutout (110) is of reduced cross section in comparison to the first section (111) and a step (113) corresponding to the difference in cross section is formed at the transition between the first section (111) and the second section (112) of the first cutout (110); and
- the three cutouts (110, 120, 130) are positioned and dimensioned in such a way that a sheath of the non-stripped portion of the cable end piece adjoins the step (113) when the litz wire (210) of the stripped portion of the cable end piece in the second section (112) of the first cutout (110) adjoins both the end of the second cutout (120) and the end of the third cutout (130).

7. Cable (200) having a soldering aid (100) according to any of the preceding claims fitted to an end piece of the cable (200).

8. Printed circuit board (300) having a soldering aid (100) according to any of the preceding Claims 1-6 fitted to a connection (310) of the printed circuit board (300).

9. Assembly comprising a cable (200), a printed circuit board (300) and a soldering aid (100) according to any of the preceding Claims 1-6, wherein the cable and the printed circuit board are connected to each other by the soldering aid (100).

10. Method for connecting a printed circuit board (300) to a cable (200), wherein the method comprises:
- forming an electrically conductive connection between a litz wire (210) of the cable (200) and a connection (310) of the printed circuit board (300) using a soldering aid (100) according to one of the preceding Claims 1-6, comprising the following steps:
- forming a solder connection between the contact structure (150) and the printed circuit board connection (310), and
- forming a solder connection between the litz wire (210) and the contact structure (150) by inserting the cable (200) into the first cutout (110), wherein the third cutout (130) keeps the solder (500) ready following corresponding filling, and by liquefying the solder (500) by introducing heat, so that the solder (500) electrically conductively connects the contact structure (150) to the litz wire (210) of the cable (200) in the second section (112) of the first cutout (110), wherein heat is introduced, for example, by laser radiation through the second cutout (120).

## Revendications

1. Aide au brasage (100) permettant de relier un câble (200) à une carte de circuit imprimé (300), comprenant :
- un corps (190) électriquement isolant doté d'un premier évidement (110), d'un deuxième évidement (120) et d'un troisième évidement (130) ; et
- une structure de contact (150) électroconductrice accouplée au corps (190), la structure de contact (150)
o étant intégrée dans le corps (190) dans certaines zones, afin d'être reliée à un brin (210) du câble (200) à l'intérieur du corps (190), et
o sortant du corps (190) dans certaines zones, afin d'être reliée à une borne (310) de la carte de circuit imprimé (300) ;
le premier évidement (110) présentant, pour la réception d'un embout du câble (200), une première portion (111) pour une partie non dénudée de l'embout de câble, la partie dénudée de l'embout de câble comprenant le brin (210),
**caractérisée**
**en ce que** le premier évidement (110) est réalisé de manière effilée en particulier de façon conique pour la réception de l'embout du câble (200),
**en ce que** le premier évidement (110) présente une deuxième portion (112) pour une partie dénudée de l'embout de câble, la structure de contact (150) étant adjacente à la deuxième portion (112) ;
**en ce que** le deuxième évidement (120) est réalisé de manière décalée spatialement par rapport au premier évidement (110) et est, par son extrémité, adjacent à la deuxième portion (112) du premier évidement (110), afin de permettre un contrôle optique de la réalisation de la liaison entre le brin (210) et la structure de contact (150) ; et
**en ce que** le troisième évidement (130) est réalisé de manière décalée spatialement par rapport au premier évidement (110) et au deuxième évidement (120) et est, par son extrémité, adjacent à la deuxième portion (112) du premier évidement (110), le troisième évidement (130) étant réalisé pour la réception et le transfert de métal d'apport de brasage (500) dans la deuxième portion (112) du premier évidement (110), afin d'y former la liaison entre le brin (210) et la structure de contact (150).

2. Aide au brasage (100) selon la revendication 1, dans laquelle le corps (190) présente un côté supérieur (191), un côté inférieur (192) et un côté frontal (193) et dans laquelle :
- la structure de contact (150) sort du corps (190) au niveau du côté inférieur de corps (192), afin d'y être reliée à la borne (310) de la carte de circuit imprimé (300) ;
- le premier évidement (110) est réalisé au niveau du côté frontal de corps (193) et s'étend dans le corps (190) parallèlement au côté inférieur de corps (191) ;
- le deuxième évidement (120) et le troisième évidement (130) sont réalisés au niveau du côté supérieur de corps (191) et s'étendent dans le corps (190) de manière décalée l'un par rapport à l'autre et perpendiculaire au côté inférieur de corps (192).

3. Aide au brasage (100) selon la revendication 1 ou 2, dans laquelle le deuxième évidement (120) et le troisième évidement (130) s'étendent parallèlement l'un à l'autre.

4. Aide au brasage (100) selon l'une des revendications précédentes, dans laquelle la structure de contact (150) est réalisée de manière profilée et sort du corps (190) par une première branche (151) et est adjacente à la deuxième portion (112) du premier évidement (110) par une deuxième branche (152).

5. Aide au brasage (100) selon la revendication 4, dans laquelle la structure de contact (150) est réalisée en forme de U ou en forme de L ou en forme de Z ou en forme de gradin.

6. Aide au brasage (100) selon l'une des revendications précédentes, dans laquelle
- la deuxième portion (112) du premier évidement (110) est de section transversale réduite par rapport à la première portion (111) et un gradin (113) correspondant à la différence de section transversale est réalisé au niveau d'une transition entre la première portion (111) et la deuxième portion (112) du premier évidement (110) ; et
- les trois évidements (110, 120, 130) sont positionnés et dimensionnés de telle sorte qu'une enveloppe de la partie non dénudée de l'embout de câble est adjacente au gradin (113) lorsque le brin (210) de la partie dénudée de l'embout de câble dans la deuxième portion (112) du premier évidement (110) est adjacent à la fois à l'extrémité du deuxième évidement (120) et à l'extrémité du troisième évidement (130).

7. Câble (200) comportant une aide au brasage (100), fixée à un embout du câble (200), selon l'une des revendications précédentes.

8. Carte de circuit imprimé (300) comportant une aide au brasage (100), fixée à une borne (310) de la carte de circuit imprimé (300), selon l'une des revendications précédentes 1 à 6.

9. Ensemble comportant un câble (200), une carte de circuit imprimé (300) et une aide au brasage (100) selon l'une des revendications précédentes 1 à 6, dans lequel le câble et la carte de circuit imprimé sont reliés l'un à l'autre par le biais de l'aide au brasage (100).

10. Procédé permettant de relier une carte de circuit imprimé (300) à un câble (200), le procédé comprenant :
- la réalisation d'une liaison électroconductrice entre un brin (210) du câble (200) et une borne (310) de la carte de circuit imprimé (300) en utilisant une aide au brasage (100) selon l'une des revendications précédentes 1 à 6, comportant les étapes suivantes :
- réalisation d'une liaison par brasage entre la structure de contact (150) et la borne de carte de circuit imprimé (310), et
- réalisation d'une liaison par brasage entre le brin (210) et la structure de contact (150) par une introduction du câble (200) dans le premier évidement (110), le troisième évidement (130) tenant le métal d'apport de brasage (500) prêt après le remplissage correspondant, et par une liquéfaction du métal d'apport de brasage (500) par apport de chaleur, de sorte que le métal d'apport de brasage (500) relie de manière électroconductrice la structure de contact (150) au brin (210) du câble (200) dans la deuxième portion (112) du premier évidement (110), l'apport de chaleur s'effectuant par exemple par rayonnement laser à travers le deuxième évidement (120).
